# EUROPEAN PATENT APPLICATION

(11) **EP 3 085 811 A1**
(43) Date of publication of application: **26.10.2016**
(21) Application number: 15164325.1
(22) Date of filing: 20.04.2015
(51) Int. Cl.: C23C 18/16, C09D 11/52, C23C 18/06, C23C 18/08, C23C 18/14, H05K 1/09, H05K 3/10

(54) **LOW TEMPERATURE AG-COMPOSITIONS**

(71) Applicant: Heraeus Deutschland GmbH & Co. KG, 63450 Hanau (DE)
(72) Inventor: Fuchs, Herbert, 63549 Ronneburg (DE); Timter, Kerstin, 63607 Wächtersbach / Aufenau (DE); Ketanis, Georgios, 63071 Offenbach (DE)
(74) Representative: Herzog, Fiesser & Partner Patentanwälte PartG mbB

(57) **Abstract**

The present invention relates to a precursor composition comprising
i) at least one silver precursor compound;
ii) at least one reducing agent;
iii) at least one solvent being different from components i) and ii);
iv) optionally at least one additive being different from components i), ii) and iii);
wherein the precursor composition comprises less than 0.1 wt.-%, based on the total weight of the precursor composition, of a binder.

The present invention also relates to a process for preparing a layered body comprising a substrate and a metal layer superimposed onto at last a part of at least one surface of the substrate, to the layer body that is obtainable by the process according to the present invention and to an electronic component comprising this layered body.

## Description

The present invention relates to a precursor composition, to a process for the production of a layered body, to a layered body obtainable by the process of the present invention and to an electronic component.

The application of metal layers in the form of coatings in electronic components is well known in the prior art. For example, the electronics, display and energy industries rely on the formation of coatings and patterns of conductive materials to form circuits on organic and inorganic substrates. The primary methods for generating these patterns are screen printing for features larger than about 100 µm and thin film and etching methods for features having a feature size not greater than about 100 µm.

WO 2013/036519 A1 discloses a method for the production of a conductive network of sintered silver, wherein a conductive ink comprising a silver compound and a binder is deposited on a substrate and wherein subsequently an external energy source is applied to dry the deposited conductive ink, followed by a further application of an external energy source to the dried conductive ink to decompose the silver compound to elemental silver and to sinter the elemental silver into a conductive network. To ensure a sufficient adhesion to substrates, the conductive ink comprises from 0.1 to 30% of a binder, based on the total weight of the conductive ink composition. However, the conductive ink disclosed in WO 2013/036519 A1 is characterized by the disadvantage that it does not allow the production of thin conductive films, in particular of conductive films having a thickness of less than 2 µm, preferably less than 1.5 µm and more preferably less than 1 µm with a sufficient low resistivity, in particular with a resistivity of less than 1 × 10⁻³ Ω·cm, preferably less than 1 × 10⁻⁴ Ω·-cm and more preferably less than 5 × 10⁻⁵ Ω·cm.

An object of the present invention is thus to reduce or even overcome at least one of the disadvantages of the state of the art.

In particular, it is an object of the present invention to provide a precursor composition that can be used for the formation of a patterned structure of a conductive material to form circuits on organic and inorganic substrates, wherein in the sintering step the structures that have been applied with the precursor composition to not significantly broaden. The conductive pattern obtained using this precursor composition should be characterized by a very low film thickness and, at the same time, a very low resistivity. Furthermore, the precursor composition should also be characterized in that it allows the formation of such a conductive pattern on a substrate at low temperatures, in particular at temperatures below 200°C such that temperature sensitive polymers can also be used as a substrate onto which the conductive pattern is applied.

A contribution to achieving at least one of the above described objects is made by the subject matter of the category forming claims of the present invention. A further contribution is made by the subject matter of the dependent claims which represent specific embodiments of the invention.

### EMBODIMENTS

|1| A precursor composition comprising
   i) at least one silver precursor compound;
   ii) at least one reducing agent;
   iii) at least one solvent being different from components i) and ii);
   iv) optionally at least one additive being different from components i), ii) and iii);
      wherein the precursor composition comprises less than 0.1 wt.-%, based on the total weight of the precursor composition, of a binder.
|2| The precursor composition according to embodiment |1|, wherein the at least one reducing agent ii) is an oxime.
|3| The precursor composition according to embodiment |2|, wherein the at least one oxime ii) is selected from the group consisting of acetone oxime, acetaldoxime, methyl ethyl ketone oxime, 2-butanonoxime, methyl isobutyl ketone oxime, cyclohexanone oxime, acetophenone oxime, benzophenone oxime, methylglyoxal oxime, ethylglyoxal oxime, methylaldoxime or a mixture of at least two thereof.
|4| The precursor composition according to to anyone of the preceding embodiments, wherein the at least one additive iv) is selected from the group consisting of a stabilizer, a defoamer, a viscosity adjusting agent and an adhesion agent.
|5| The precursor composition according to embodiment |4|, wherein the viscosity adjusting agent is a polyol. I.
|6| The precursor composition according to embodiment |4|, wherein the stabilizer is an amine or a carboxylic acid.
|7| The precursor composition according to embodiment |6|, wherein the amine is tris(2-aminoethyl)amine (Tris).
|8| The precursor composition according to anyone of the preceding embodiments, wherein the precursor composition is an ink or a paste.
|9| The precursor composition according to anyone of the preceding embodiments, wherein the at least one silver precursor compound i) is a metal-organic silver compound.
|10| The precursor composition according to embodiment |9|, wherein the organic component of the metal-organic silver compound i) comprises a molecule with at least one carbon atom.
|11| The precursor composition according to embodiment |10|, wherein the organic component of the metal-organic silver compound i) comprises at least one non-metal atom which at least coordinates with silver.
|12| The precursor composition according to embodiment |11|, wherein the non-metal atom is selected from the group consisting of oxygen, sulfur, nitrogen, phosphorus and a combination of at least two thereof.
|13| The precursor composition according to embodiment |12|, wherein the organic component of the metal-organic silver compound i) is selected from the group consisting of an alkoxide, a carbonate, an oxalate, an ester, a carboxylate, a halogencarboxylate, a hydroxycarboxylate, an acetonate, a ketonate, an acrylate, an alkenylether, an oxime and a mixture of at least two thereof.
|14| The precursor composition according to embodiment |13|, wherein the organic component of the metal-organic silver compound i) is a carboxylate.
|15| The precursor composition according to embodiment |14|, wherein the metal-organic silver compound i) is silver neodecanoate.
|16| The precursor composition according to anyone of the preceding embodiments, wherein the precursor-composition comprises, in addition to the silver precursor compound i), at least one further metal precursor compound i-2), in which the metal is different from silver.
|17| The precursor composition according to anyone of the preceding embodiments, wherein the at least one solvent iii) has a boiling point determined at 1013 mbar of at least 60°C.
|18| The precursor composition according to anyone of the preceding embodiments, wherein the at least one solvent iii) is selected from the group consisting of heptane, hexane, methanol, ethanol, butanol, propanol, acetone, γ-butyrolactone, N-methyl-2-pyrrolidone, acetonitrile, nitromethane, triethylamine, dimethylformamide, dimethylsulfoxide, sulfolane, ethylene carbonate, ethylene glycol monobutyl ether, dimethylcarbonate, propylene glycol methylether acetate, propylene glycol methylether acetate, acetaldehyde oxime, butanone oxime, rosemary oil, lavender or an spike oil, a turpentine oil, a campher oil, a lime oil, texanol, terpineol and a mixture of at least two thereof.
|19| The precursor composition according to embodiment |18|, wherein the at least one solvent iii) is terpineol.
|20| The precursor composition according to anyone of the preceding embodiments, wherein the precursor composition comprises less than 0.1 wt.-%, based on the total weight of the precursor composition, of a binder selected from the group consisting of polypyrrolidone, epoxies, phenolic resins, acrylics, urethanes, silicones, styrene allyl alcohols, polyalkylene carbonates, polyesters and polyvinyl acetals and combinations thereof.
|21| The precursor composition according to anyone of the preceding embodiments, wherein the precursor composition comprises
   - 5 to 80 wt.-% of the at least one silver precursor compound i);
   - 1 to 20 wt.-% of the at least one reducing agent ii);
   - 10 to 90 wt.-% of the at least one solvent iii);
   - 0.05 to 10 of at least one additive iv);
      wherein total amount of components i) to iv) is 100 wt.-%.
|22| A process for preparing a layered body comprising a substrate and a metal layer superimposed onto at last a part of at least one surface of the substrate, comprising the process steps:
   I) providing a substrate;
   II) superimposing at least a part of at least one surface of the substrate with the precursor composition according to anyone of the preceding embodiments;
   III) applying an external energy source to convert the precursor composition into a metal layer comprising silver.
|23| The process according to embodiment |22|, wherein the substrate is selected from the group consisting of a polymer, a metal, a paper, a ceramic, a glass or a combination of at least two thereof.
|24| A layered body obtainable by the process according to embodiment |22| or |23|.
|25| The layered body according to embodiment |24|, wherein the metal layer comprises less than 5 wt.-% of an organic moiety.
|26| The layered body according to embodiment |24| or |25|, wherein the metal layer comprises less than 5 wt.-% of a binder.
|27| The layered body according to anyone of embodiments |24| to |26|, wherein the metal layer is characterized by at least one of the following properties:
   P1) a resistivity less than 1 × 10⁻⁴ Ω·cm;
   P2) a thickness of less than 2 µm.
|28| An electronic component comprising a layered body according to anyone of embodiment |24| to |27|.
|29| The electronic component of embodiment |28|, wherein the electronic component is selected from the group consisting of an Organic Light Emitting Diode (OLED), a Light Emitting Diode (LED), a display, a transistor, a capacitor, a smart tag, a smart label, a radio frequency identification (RFID) tag, a sensor, a circuit, a touch screen, a light emitting electrochemical cell, an antistatic coating, an ESD shielding layer and a solar cell.

The invention relates to a precursor composition comprising, preferably consisting of
i) at least one silver precursor compound;
ii) at least one reducing agent;
iii) at least one solvent being different from components i) and ii);
iv) optionally at least one additive being different from components i), ii) and iii);
   wherein the precursor composition comprises less than 0.1 wt.-%, preferably less than 0.05 wt.-% and more preferably less than 0.01 wt.-%, in each case based on the total weight of the precursor composition, of a binder. According to a preferred embodiment of the precursor composition the composition is free of a binder.

In this context it particularly preferred that the precursor composition comprises less than 0.1 wt.-%, preferably less than 0.05 wt.-% and more preferably less than 0.01 wt.-%, in each case based on the total weight of the precursor composition, of a binder selected from the group consisting of polypyrrolidone, epoxies, phenolic resins, acrylics, urethanes, silicones, styrene allyl alcohols, polyalkylene carbonates, polyesters and polyvinyl acetals and combinations thereof, wherein it is most preferred that the precursor composition is free of any of these binders.

Surprisingly it has been discovered that although the precursor composition according to the present invention is substantially free of any binders, a good adhesion of the conductive silver layer on a substrate onto which the precursor composition has been applied is nonetheless achieved after converting the precursor composition into a metal layer comprising silver by means of applying an external energy source. The absence of any binders in the precursor composition allows the preparation of very thin silver layers which, despite the low thickness, do have a sufficiently low resistivity to be used as conductive layers in electronic components.

As used herein, the term "precursor composition" refers to a flowable, preferably a liquid composition that can be treated, such as by heating, to form an electronic feature. The precursor composition can, for example, be an ink or a paste. According to the present invention, the precursor composition is deposited onto a substrate and the viscosity of the composition is typically not critical. The viscosity will, however, affect the type of tool that can be used to deposit the precursor composition. In this regard, the precursor compositions can be formulated to have a high viscosity of at least about 1000 centipoise, such as at least 5000 centipoise. According to one embodiment, the precursor composition has a viscosity of greater than about 10000 centipoise. Such compositions are commonly referred to as pastes. Alternatively, the precursor compositions can be formulated to have a low viscosity, such as not greater than about 1000 centipoise, to enable the deposition of the composition by methods such as ink-jet deposition. Such low viscosity compositions can have a viscosity of not greater than 500 centipoise, preferably not greater than 100 centipoise and even more preferably not greater than 50 centipoise. As used herein, the viscosity is measured under the relevant deposition conditions. For example, some precursor compositions may be heated prior to and/or during deposition to reduce the viscosity.

According to a preferred embodiment of the precursor composition according to the present invention the at least one silver precursor compound i) is a metal-organic silver compound.

The organic component of the metal-organic silver compound preferably comprises a molecule with at least one, at least two or more carbon atoms, preferably in a range from 2 to 100, or preferably in a range of from 4 to 50, or preferably in a range of from 5 to 20 carbon atoms. According to a preferred embodiment of the organic component of the metal-organic compound this component comprises at least one C=C or at least one C≡C moiety or both.

The organic component preferably also comprises one or two or more non-metal atoms. It is preferred that at least one, two or more non-metal atoms at least coordinate, or preferably form a bond, with silver. The non-metal atoms are preferably selected from the group of oxygen, hydrogen, sulfur, nitrogen, phosphorus and a combination of at least two thereof.

Preferably, the organic component of the metal-organic silver comprises an organic moiety wherein the non-metal atoms or the at least one C=C or the at least one C≡C moiety or both build at least one organic molecule together with the at least one, two or more carbon atom.

According to the invention, the organic moiety may comprise a C=O group or a C-O⁻ group. Further to the C=O group, the organic moiety preferably comprises at least two carbon atoms and preferably at least one nonmetal atom as mentioned above.

In a preferred embodiment of the precursor composition according to the present invention the organic moiety of the metal-organic compound is selected from the group consisting of an alkoxide, a carbonate, an oxalate, an ester, a carboxylate, a halogencarboxylate, a hydroxycarboxylate, an acetonate, a ketonate, an acrylate, an alkenylether, an oxime and a mixture of at least two thereof, wherein a carboxylate is particularly preferred. For example, the organic moiety can be selected from the group consisting of acetate, proprionate, butanoate, ethylbutyrate, pivalate, cyclohexanebutyrate, acetylacetonate, ethylhexanoate, hydroxypropionate, trifluoracetate, hexafluor-2,4-pentadionate, neodecanoate and a mixture of at least two thereof.

Suitable silver precursor compounds i) can be selected from the group consisting of silver (I) neodecanoate, silver (I) trifluoroacetate, silver (I) acetate, silver (I) lactate, silver (I) cyclohexanebutyrate, silver (I) carbonate, silver oxalate, silver malonate, silver (I) oxide, silver (I) ethylhexanoate, silver (I) acetylacetonate, silver (I) ethylbutyrate, silver (I) pentafluoropropionate, silver (I) benzoate, silver (I) citrate, silver (I) heptafluorobutyrate, silver (I) salicylate, silver (I) decanoate, silver (I) glycolate, silver (I) β-ketocarboxylate, such as silver (I) i-butyryl-acetate, silver (I) acetoacetate, silver (I) propionylacetate, silver (I) benzoylacetate, silver (I) α-methylacetoacetate, silver (I) α-ethylacetoacetate and silver (I) carbamates, like silver ethylhexylammonium-2-ethylhexylcarbamate. Also suitable are silver carboxylate amine complexes, like silver acetate ethanolamine, or silver polyethercarboxylates and the substituted analogues of the general formula:

[M⁺] [-OOC-CR¹R²-(OCR³R⁴-CR⁵R⁶)_{z}-O-CR⁷R⁸-CR⁹R¹⁰-X-R¹²]

wherein
- M: represents Ag;
- R¹, R²: independently from each other represent hydrogen, a halogen, an alkyl-group or an aryl-group;
- R³ to R¹⁰: independently from each other represent hydrogen, a methyl-group, F or a trifluormethyl-group;
- z: represents an integer in the range from 1 to 10
- X: represents O, S or a group NR¹¹, in which R¹¹ represents an alkyl-group, an aryl-group, wherein the alkyl-group and the aryl-group can be substituted;
- R¹²: represents an alkyl-group or an aryl-group, wherein the alkyl-group and the aryl-group can be partially or totally fluorinated.

In this context particularly preferred as silver precursor compound i) is silver neodecanoate.

The precursor composition according to the present invention can, besides one or more of the above mentioned silver precursor compounds i), also comprise one or more further metal precursor compounds i-2), in which the metal is different from silver, such as palladium precursor compounds, copper precursor compounds or a mixture thereof.

Suitable palladium precursor compounds i-2) can be selected from the group consisting of palladium (II) carboxylates, including palladium (II) fluorocarboxylates such as palladium (II) acetate, palladium (II) propionate, palladium (II) ethylhexanoate, palladium (II) neodecanoate and palladium (II) trifluoroacetate as well as mixed carboxylates such as Pd(II)(OOCH)(OAc), Pd(II)(OAc)(ethylhexanoate), Pd(II)(ethylhexanoate)₂, Pd(II)(OOCH)_{1.5}(ethylhexanoate)_{0.5}, Pd(II)(OOCH)(ethylhexanoate), Pd(II)(OOCCH(OH)CH(OH)COOH)ₘ(ethylhexanoate), Pd(II)(OPr)₂, Pd(II)(OAc)(OPr), palladium (II) oxalate, Pd(II)(OOCCHO)ₘ(OOCCH₂OH)ₙ= (glyoxilic palladium glycolate), palladium (II) alkoxides, palladium (II) β-diketonates such as palladium (II) acetylacetonate or palladium polyethercarboxylates and the substituted analogues of the general formula:

[Mⁿ⁺] [~OOC-CR¹R²-(OCR³R⁴-CR⁵R⁶)_{z}-O-CR⁷R⁸-CR⁹R¹⁰-X-R¹²]ₙ

wherein
- M: represents Pd;
- n: represents 2 or 4;
- R¹, R²: independently from each other represent hydrogen, a halogen, an alkyl-group or an aryl-group;
- R³ to R¹⁰: independently from each other represent hydrogen, a methyl-group, F or a trifluormethyl-group;
- z: represents an integer in the range from 1 to 10
- X: represents O, S or a group NR¹¹, in which R¹¹ represents an alkyl-group, an aryl-group, wherein the alkyl-group and the aryl-group can be substituted;
- R¹²: represents an alkyl-group or an aryl-group, wherein the alkyl-group and the aryl-group can be partially or totally fluorinated.

Suitable copper precursor compounds i-2) can be selected from the group consisting of copper (II) carboxylates and copper (II) fluorocarboxylates such as copper (II) formate, copper (II) acetate, copper (II) i-butyrate, copper (II) ethylhexanoate, copper (II) neodecanoate, copper (II) methacrylate, copper (II) trifluoroacetate, copper (II) hexanoate, copper (II) β-diketonates such as copper (II) acetylacetonate, copper (II) alkoxides such as copper (II) methoxide or copper (II) t-butoxide, copper (I) pentanoxide, copper (I) methyl-12-pentanoxide, copper (I) formiate or copper formiate compounds of the formula

LₙCu(HCOO) × HCOOH

wherein
- ×: represents an integer in the range from 0 to 10
- n: represents an integer in the range from 1 to 4
- L: independently from each other represents a Ligand selected from the group consisting of a phosphine (R¹)(R²)(R³)P, a phosphite (R¹O)(R²O)(R³O)P, an alkene R¹R²C=C³R⁴ or an alkine R¹C=-CR², wherein R¹, R², R³, R⁴ can be hydrogen, an alkyl-group, an aryl-group, an aminoalkyl-group, an alkoxyalkyl-group, a hydroxyalkyl-group, a phosphonoalkyl-group or an aryl-groups, wherein these groups can be partially or totally fluorinated.

Also suitable are copper polyethercarboxylates and the substituted analogues of the general formula:

[Mⁿ⁺] [⁻OOC-CR¹R²-(OCR³R⁴-CR⁵R⁶)_{z}-O-CR⁷R⁸-CR⁹R¹⁰-X-R¹²]ₙ

wherein
- M: represents Cu;
- n: represents 1 or 2;
- R¹, R²: independently from each other represent hydrogen, a halogen, an alkyl-group or an aryl-group;
- R³ to R¹⁰: independently from each other represent hydrogen, a methyl-group, F or a trifluormethyl-group;
- z: represents an integer in the range from 1 to 10
- X: represents O, S or a group NR¹¹, in which R¹¹ represents an alkyl-group, an aryl-group, wherein the alkyl-group and the aryl-group can be substituted;
- R¹²: represents an alkyl-group or an aryl-group, wherein the alkyl-group and the aryl-group can be partially or totally fluorinated.

As component ii) the precursor composition according to the present invention comprises at least one reducing agent, wherein the reducing agent can be selected from the group consisting of
- amines for example butyl amine, nonylamine, dibutyl amine, tributyl amine, diethylene amine, tetraethylene pentamine, octylamine, triethyl amine, isopropanolamine, TRIS (Tris(hydroxymethyl)aminomethane) and a mixture of at least two thereof,
- oximes such as acetonoxime, acetaldehydoxime, methyl ethyl ketone oxime, 2-butanonoxime, methyl isobutyl ketone oxime, cyclohexanone oxime, acetophenone oxime, benzophenone oxime, methylglyoxal oxime, ethylglyoxal oxime, methylaldoxime or a mixture of at least two thereof,
- guanidines such as guanidine carbonate,
- carbazones such as diphenylcarbazone,
- alcohols or polyols, such as methanol, ethanol, isopropanol, terpineol, t-butanol, ethylene glycol, diethylene glycol, triethylene glycol, 2,5-dimethyl-2,5-hexandiol, di-(trimethylol)propane, 1,1,1-tris-(hydroxymethylpropane), 2,2-Dimethyl-1,3-propandiol or a mixture of at least two thereof,
- hydrazines, such as hydrazine, hydrazine hydrochloride, hydrazine sulfate, hydrazine hydrate or a mixture of at least two thereof
- hydrazones or hydrazides,
- aldehydes such formaldehyde, octanal, decanal, dodecanal or a mixture of at least two thereof, and
- amides such as dimethylformamide or nicotinamide.

According to a particularly preferred embodiment of the precursor composition according to the present invention the at least one reducing agent ii) is an oxime, preferably an oxime selected from the group consisting of acetone oxime, acetaldoxime, methyl ethyl ketone oxime, 2-butanonoxime, methyl isobutyl ketone oxime, cyclohexanone oxime, acetophenone oxime, benzophenone oxime, methylglyoxal oxime, ethylglyoxal oxime, methylaldoxime or a mixture of at least two thereof.

The precursor composition according to the present invention comprises as component iii) at least one solvent being different from components i) and ii). The selected solvent should be capable of solubilizing the selected silver precursor compound i) to a high level. A low solubility of the silver precursor compound in the solvent leads to low yields of the conductor, thin deposits and low conductivity. According to one embodiment of the precursor composition according to the present invention, the solubility of the silver precursor compound i) in the solvent iii) is preferably at least about 20 weight percent silver precursor compound i), more preferably at least 40 weight percent silver precursor compound i), even more preferably at least about 50 weight percent silver precursor compound i) and most preferably at least about 60 weight percent silver precursor compound i). Such high levels of silver precursor compound i) lead to increased metal yield and the ability to deposit features having adequate thickness. Preferably, the solvent iii) has a boiling point determined at 1013 mbar of at least 60°C, more preferably of at least 80°C. Examples of suitable solvents are solvents selected from the group consisting of heptane, hexane, methanol, ethanol, butanol, propanol, acetone, γ-butyrolactone, N-methyl-2-pyrrolidone, acetonitrile, nitromethane, triethylamine, dimethylformamide, dimethylsulfoxide, sulfolane, ethylene carbonate, ethylene glycol monobutyl ether, dimethylcarbonate, propylene glycol methylether acetate, propylene glycol methylether acetate, acetaldehyde oxime, butanone oxime, rosemary oil, lavender or an spike oil, a turpentine oil, a campher oil, pine oil, a lime oil, spike oil, peppermint oil, texanol, terpineol and a mixture of at least two thereof, wherein the use of terpineol, texanol and turpentine oil is particularly preferred and the use of terpineol is most preferred.

The precursor composition according to the present invention may also comprise at least one further additive iv) being different from the previously mentioned components i), ii) and iii). Suitable additives include additives selected from the group consisting of
- the previously mentioned further metal precursor compound i-2), in which the metal is different from silver,
- a stabilizer, preferably an amine such as Tris(2-aminoethyl)amine, or a carboxylic acid,
- a defoamer such as BYK-065 available from BYK-Chemie GmbH,
- a viscosity adjusting agent such as a polyol or campher, and
- or an adhesion agent, such as 3-glycidoxypropyltrimethoxysilane.

The precursor composition according to the present invention can also include an adhesion promoter as a further additive iv) adapted to improve the adhesion of the conductive metal layer to the underlying substrate. In addition, the precursor composition can include rheology modifiers as a further additive iv). As an example, styrene allyl alcohol (SM) can be added to the precursor composition to reduce spreading on the substrate.

It is furthermore preferred that the precursor composition according to the present invention comprises, preferably consists of
- 5 to 80 wt.-%, preferably 20 to 75 wt.-% and most preferably 35 to 70 wt.-% of the at least one silver precursor compound i), wherein, if two or more silver compounds are present, these amounts refer to the total amount of silver precursor compounds;
- 1 to 20 wt.-%, preferably 2.5 to 17.5 wt.-% and most preferably 5 to 15 wt.-% of the at least one reducing agent ii), wherein, if two or more reducing agents are present, these amounts refer to the total amount of reducing agents;
- 10 to 90 wt.-%, preferably 12.5 to 70 wt.-% and most preferably 15 to 50 wt.-% of the at least one solvent being different from components i) and ii), wherein, if two or more solvents being different from components i) and ii) are present, these amounts refer to the total amount of solvents being different from components i) and ii);
- 0.05 to 10 wt.-%, preferably 0.1 to 7.5 wt.-% and most preferably 1 to 5 wt.-% of the at least one further additive iv) being different from components i) to iii), wherein, if two or more further additives iv) being different from components i) to iii) are present, these amounts refer to the total amount of further additives iv) being different from components i) to iii);
wherein the total amount of components i) to iv) is 100 wt.-%. In some cases solvents employed in the present invention might also coordinate with silver in the silver-organic compound i). In these cases the amount on such compound in addition to the amount which coordinates with silver is considered to act as a solvent.

The precursor composition according to the present invention can be prepared by simply dissolving the silver precursor compound i), the reducing agent ii) and optionally the at least one further additive iv) in the solvent iii) in any order. It may be advantageous to heat the solvent iii), preferably to a temperature in the range from 30 to 100°C (wherein the maximum temperature will of course be dependent from the boiling point of the solvent) and to dissolve the silver precursor compound i) in the heated solvent. The hot solution can then be filtered and cooled down to room temperature.

The invention also relates to a process for preparing a layered body comprising a substrate and a metal layer superimposed onto at last a part of at least one surface of the substrate, comprising the process steps:
I) providing a substrate;
II) superimposing a least a part of at least one surface of the substrate with the precursor composition according to the present invention;
III) applying an external energy source to convert the precursor composition into a metal layer comprising silver.

In process step I) of the process according to the present invention a substrate is provided, wherein the substrate may be selected from the group consisting of a glass, a polymer, a ceramic, a paper, a metal oxide and a metal or a combination of at least two thereof. Preferably, the material of the substrate comprises a polymer foil, a ceramic, a glass or a combination of at least two thereof. The glass is preferably selected from the group consisting of soda-lime glass, lead alkali glass, borosilicate glass, aluminosilicate glass, fused silica, non alkaline glass or mixtures of at least two thereof. The polymer of the polymer foil is preferably selected from the group consisting of a polyethylene, a polypropylene, a polystyrene, a polyimide, a polycarbonate and a polyester or a combination of at least two thereof. Preferably, the polymer is selected from the group of a poly (ethylene therephthalate), polyethylene naphthalate, polybismaleinimid (PBMI), polybenzimidazol (PBI), polyoxadiazobenzimidazol (PBO), polyimidsulfon (PISO) and polymethacrylimid (PMI) or a mixture of at least two thereof. It is preferred that the substrate comprises a polymer in a range of 10 to 100 wt.-%, or preferably in a range of from 20 to 95 wt.-%, or preferably in a range of from 30 to 90 wt.-%.

The substrate can have any form or geometry that is suitable for use in a multi-layer composite precursor. The substrate preferably has the form or geometry of a layer. The thickness of the substrate preferably lies in a range of from 0.1 to 1000 µm, more preferably in a range of from 1 to 500 µmm, or preferably in a range of from 1 to 100 µm. The substrate preferably has an areal extension, defined as the product of the width and the length, in a range of from 0.01 mm² to 1000000 cm², or preferably in a range of from 0.1 mm² to 500000 cm², or preferably in a range of from 1 mm² to 100000 cm². The substrate preferably comprises a first and a second surface. The first and the second surface of the substrate are preferably provided on the areal extension of the substrate. Preferably, the two surfaces are on opposite sides of the substrate, which is particularly preferred if the substrate is a layered structure, such as a plate, a disc or a bar.

According to a particularly preferred embodiment of the process according to the present invention the substrate is selected from the group consisting of
- glass,
- glass superimposed with a transparent conductive oxide (TCO) or with a conductive polymer, wherein in process step II) the precursor composition according to the present invention is superimposed onto at least a part of the surface of the transparent conductive oxide or the conductive polymer;
- a polymer foil; and
- a polymer foil superimposed with a transparent conductive oxide (TCO) or with a conductive polymer, wherein in process step II) the precursor composition according to the present invention is superimposed onto at least a part of the surface of the transparent conductive oxid or the conductive polymer.

Suitable materials for the TCO layer can be any metal oxides including, but not limited to, oxides of Ag, Al, Cu, Cr, Zn, Mo, Wo, Ca, Ti, In, Sn, Ba, Ti or Ni. Preferred materials are oxides of In, in particular indium tin oxide (ITO), Zn, Sn and BaTiO. The TCO layer may be optionally doped with one or more metals selected from Al, Ga, Sb or other materials such as F and the dopants are in an amount of less than 5 wt %, preferably less than 2 wt % on the basis of the total weight of the TCO layer. Examples of the doped metal oxides for the TCO layer include ZnO:Al (AZO), ZnO:Ga (GZO), SnO₂:Sb (ATO), SnO₂:F (FTO) and BaTiO. The thickness of the TCO-layer can be adjusted to arrive at a desirable transparency and resistivity and is preferably 0.1 µm to 3 µm, more preferably 0.3 µm to 0.8 µm.

Suitable conductive polymers are polyacetylenes, polyanilines, polyparaphenylenes, polypyrrols or polythiophenes, in particular conductive polymer layers that have been prepared using PEDOT/PSS-dispersions.

In process step II) at least a part of at least one surface of the substrate is superimposed with the precursor composition according to the present invention. In case of a substrate a surface of which is superimposed with a TCO-layer or a conductive polymer as described above the composition according to the present invention is preferably superimposed onto at least a part of the TCO-layer or the conductive polymer layer.

The precursor composition according to the present invention can be superimposed onto at least a part of at least one surface of the substrate by any method the person skilled in the art would use to supply an at least partially fluid component, like the precursor composition according to the present invention, onto a preferably solid substrate. Superimposing is preferably achieved by spraying, printing, laying, coating impregnating or dipping or a combination thereof, preferably by printing. According to the invention, at least printing is a form of superimposing at least a part of a surface, wherein the precursor composition according to the present invention is applied via an aid in the form of a device onto the surface of the substrate. This can be achieved by different forms of aids. The precursor composition can, for example, be applied via a nozzle or valve by extruding, spraying or jetting. The precursor composition can be applied by coating e.g. brushing, roller superimposing, dip coating or curtain coating. Alternatively or additionally, the precursor composition can be applied or printed via a roll or a drum. As printing methods, gravure printing via a roll or ink-jet printing through an opening, e.g. a nozzle or valve, as well as the screen printing through a mesh, offset printing, flexo printing, tampon printing and spin coating are well known. During the superimposing process, pressure can be applied to the precursor composition or the substrate. Alternatively, the precursor composition is applied using gravity alone. In case of coating a substantial uniform coverage of a surface is desired. In case of printing, however, a two dimensional pattern is formed in the coverage of a surface.

The nozzle or valve can operate by a piezo element or a pneumatic valve as they are often used for ink-jet printers. These valves have the property of building portions of the applied precursor composition that might preferably be applied under pressure to the surface. The portions of the precursor composition preferably have a volume in a range of from 0.1 to 500 nl, or preferably in a range of from 1 to 100 nl, or preferably in a range of from 10 to 50 nl.

In the gravure printing process, the surface to be superimposed is fed between two rolls which are in contact with each other. One roll is called the impression roll and the other roll is called the gravure roll because the liquid phase comes into contact with it. By guiding the substrate between the contacting rolls with the first surface facing towards the gravure roll, the precursor composition according to the present invention can be transferred to the first surface of the substrate.

In the screen printing process the precursor composition is urged through a mesh onto the surface of the substrate. This can be achieved only by gravity or alternatively or additional by using a squeegee or doctor knife.

With these application or coating methods it is possible to create a pattern of the precursor composition according to the present invention onto the surface of the substrate. Preferably, lines or grids are formed by the superimposing process. The lines can have a width in a range of from 0.01 to 10000 µm, preferably in a range of from 0.05 to 1000 µm, or preferably in a range of from 0.1 to 500 µm. The lines of the grid can lie in the same ranges as mentioned for the lines.

In process step III) an external energy source is applied to convert the precursor composition into a metal layer comprising silver, wherein the application of an external energy source is preferably accomplished by a heat-treatment of the superimposed substrate at a temperature in a range from 100 to 400°C. The temperature of the conversion of the silver precursor compound i) into the corresponding metal, also called conversion temperature, is dependent on different factors. The conversion temperature, for example, depends on the composition of the precursor composition. It can also depend on the surrounding conditions, like pressure, humidity or light intensity, which could be IR, synthetic light or daylight. The heating can preferably be established by a method selected from the group consisting of irradiation with electromagnetic waves and convection or a combination thereof. The irradiation can preferably be provided by a lamp, for example by an excimer lamp, flash lamp, UV- or an infrared lamp. The convection can preferably be provided to the precursor composition by a hot fluid, for example hot air or hot liquid. Preferably, the substrate superimposed with the precursor composition is heated in a cabinet that is heated electrically. The fluid in the cabinet can be selected from the group consisting of air, nitrogen gas and inert gas or mixtures of at least two thereof. The liquid phase is preferably heated to a temperature in a range of from 100 to 400°C, or preferably in a range of from 125 to 350°C, or preferably in a range of from 150 to 300°C. The treating time is generally in the range from 1 minute to 120 minutes, preferably 5 minutes to 60 minutes and most preferably 10 minutes to 45 minutes.

By heating the precursor composition according to the present invention to a temperature in these ranges, the silver precursor compounds i) preferably changes its composition. In this context it is particularly preferred that the precursor composition is converted into a metal layer comprising silver, wherein the metal layer comprises less than 10 wt.-%, preferably of less than 8 wt.-% and more preferably of less than 5 wt.-% of an organic moiety, in each based on the total weight of the metal. In this context it is particularly preferred that the precursor composition is converted into a metal layer comprising silver, wherein this metal layer comprises less than 10 wt.-%, preferably of less than 8 wt.-% and more preferably less than 5 wt.-% of a binder, in each based on the total weight of the metal layer. According to a particularly preferred embodiment of the process according to the present invention the precursor composition is converted into a metal layer comprising silver, wherein the metal layer is free of any organic moiety, preferably free of any binder.

According to a preferred embodiment of the process according to the present invention the process may further comprise the process step
IV) at least partially superimposing the metal layer comprising silver that is obtained in process step III) with a transparent conductive layer, preferably with a transparent conductive oxide (TCO) or a conductive polymer, particularly preferred with a conductive polymer.

Preferred conductive oxides (TCO) and conductive polymers are those oxides and polymers that have been previously mentioned in connection with process step (I).

The invention also relates to a layered body obtainable by the process according to the present invention. This layered body comprises the substrate at least one surface of which is superimposed with a metal layer comprising silver. Preferably, the metal layer comprises less than 10 wt.-%, preferably of less than 8 wt.-% and more preferably of less than 5 wt.-% of an organic moiety, in each based on the total weight of the metal. In this context it is particularly preferred that the metal layer comprises less than 10 wt.-%, preferably of less than 8 wt.-% and more preferably less than 5 wt.-% of a binder, in each based on the total weight of the metal layer. According to a particularly preferred embodiment of the layered body obtainable by the process according to the present invention the metal layer is free of any organic moiety, preferably free of any binder.

It is also preferred that the metal layer of the layered body obtainable by the process according to the present invention is characterized by at least one of the following properties, preferably by both of the following properties:
P1) a resistivity of less than 1 × 10⁻³ Ω·cm, preferably less than 1 × 10⁻⁴ Ω·-cm and most preferably less than 5 × 10⁻⁵ Ω·cm;
P2) a thickness of less than 2 µm, preferably less than 1.5 µm most preferably less than 1.0 µm.

The present invention also relates to an electronic component comprising a layered body obtainable by the process according to the present invention.

In a preferred embodiment of the electronic component, the electronic component is selected from the group consisting of an Organic Light Emitting Diode (OLED), a Light Emitting Diode (LED), a display, a transistor, a capacitor, a smart tag, a smart label, a radio frequency identification (RFID) tag, a sensor, a circuit, a touch screen, a light emitting electrochemical cell, an antistatic coating, an ESD shielding layer and a solar cell.

Organic light emitting displays are emissive displays consisting of a transparent substrate superimposed with a transparent conducting material (e.g., ITO), one or more organic layers and a cathode made by evaporating or sputtering a metal of low work function characteristics (e.g., calcium or magnesium). The organic layer materials are chosen so as to provide charge injection and transport from both electrodes into the electroluminescent organic layer (EL), where the charges recombine to emit light. There may be one or more organic hole transport layers (HTL) between the transparent conducting material and the EL, as well as one or more electron injection and transporting layers between the cathode and the EL. The precursor composition according to the present invention enables, for example, the printing of row and column address lines for OLEDs. These lines can be printed with a thickness of about one µm and a line width of 100 µm using ink-jet printing. These data lines can be printed continuously on large substrates with an uninterrupted length of several meters.

The composition according to the present invention can also be used to prepare electrical interconnects and electrodes for liquid crystal displays (LCDs), including passive-matrix and active-matrix. Particular examples of LCDs include twisted nematic (TN), supertwisted nematic (STN), double supertwisted nematic (DSTN), retardation film supertwisted nematic (RFSTN), ferroelectric (FLCD), guest-host (GHLCD), polymer-dispersed (PD), polymer network (PN).

The composition according to the present invention can also be used prepare electrical interconnects and electrodes in transistors. Thin film transistors (TFTs) are well known in the art, and are of considerable commercial importance. Amorphous silicon-based thin film transistors are used in active matrix liquid crystal displays. One advantage of thin film transistors is that they are inexpensive to make, both in terms of the materials and the techniques used to make them. In addition to making the individual TFTs as inexpensively as possible, it is also desirable to inexpensively make the integrated circuit devices that utilize TFTs. Accordingly, inexpensive methods for fabricating integrated circuits with TFTs, such as those of the present invention, are an enabling technology for printed logic. Organic thin film transistors (TFTs) are expected to become key components in the plastic circuitry used in display drivers of portable computers and pagers, and memory elements of transaction cards and identification tags. A typical organic TFT circuit contains a source electrode, a drain electrode, a gate electrode, a gate dielectric, an interlayer dielectric, electrical interconnects, a substrate, and semiconductor material. The precursor composition of the present invention can be used to deposit all the components of this circuit, with the exception of the semiconductor material. One of the most significant factors in bringing organic TFT circuits into commercial use is the ability to deposit all the components on a substrate quickly, easily and inexpensively as compared with silicon technology (i.e., by reel-to-reel printing). The precursor composition of the present invention enables the use of low cost deposition techniques, such as ink-jet printing, for depositing these components.

The precursor compositions of the present invention is also useful for the direct printing of electrical connectors as well as antennae of smart tags, smart labels, and a wide range of identification devices such as radio frequency identification (RFID) tags. In a broad sense, the precursor composition according to the present invention can be utilized for electrical connection of semiconductor radio frequency transceiver devices to antenna structures and particularly to radio frequency identification device assemblies. A radio frequency identification device ("RFID") by definition is an automatic identification and data capture system comprising readers and tags. Data is transferred using electric fields or modulated inductive or radiating electromagnetic carriers. RFID devices are becoming more prevalent in such configurations as, for example, smart cards, smart labels, security badges, and livestock tags.

The precursor composition according to the present invention can also be used to prepare a conductive pattern serving as an electronic circuit in a photovoltaic panel. Currently, conventional screen-printing is used in mass scale production of solar cells. Typically, the top contact pattern of a solar cell consists of a set of parallel narrow finger lines and wide collector lines deposited essentially at a right angle to the finger lines on a semiconductor substrate or wafer. Such front contact formation of crystalline solar cells is performed with standard screen-printing techniques. Direct printing of these contacts with the precursor composition according to the present invention provides the advantages of production simplicity, automation, and low production cost.

The precursor composition according to the present invention can also be used to prepare an electrical contact on a solid electrolyte capacitor. A solid electrolyte capacitor is usually prepared by anodizing a valve-metal pellet, coating the dielectric oxide thus formed with a solid electrolyte, applying a layer of graphite or colloidal carbon as a cathode contact to the solid electrolyte (or a further conductive polymeric outer layer that is applied onto the solid electrolyte), and applying a layer of silver paint or silver epoxy over the carbon. It is also conventional to solder a cathode lead to the silver layer after the layer is cured. The precursor composition according to the present invention can thus be applied onto the cathode contact, for example onto a layer of graphite or colloidal carbon and can subsequently be converted into a metal layer comprising silver by applying an external energy source to produce an electrical contact on a solid electrolyte capacitor.

The above and other features and advantages of the invention will be apparent from the following description, by way of example, of embodiments of the invention with reference to the accompanied drawing. The particular features can be realized here by themselves or several in combination with one another. The invention is not limited to the embodiment examples.

### TEST METHODS

### Determination of the specific surface resistance and specific resistance

For measuring the specific surface resistance of a multi-layer composite precursor or of a multi-layer composite according to the invention a device "CMT-SR 3000" by the company AiT Co., Ltd. was used. For the measuring 4 point measuring principle is applied. Therefore two outer probes in form of pins apply a constant current and tow inner probes measure the voltage on a rectangular probe. The specific resistance p (in Ω·cm) is calculated based on the value for the specific surface resistance R_{S}. (in Ω/sq) using the equation p = R_{S} × t, wherein t is the film thickness.

As the specific surface resistance can be influenced by the dopant concentration, the resistivity can vary from the outside to the inside of the composite precursor or the composite. To determine the average specific surface resistance generally the measurement is performed on 25 equally distributed spots of the composite precursor or composite, wherein the spots all had equal distances to each other.

In an air conditioned room with a temperature of 23 ± 1 °C all equipment and materials are equilibrated to the temperature of 23 °C before the measurement. To perform the measurement the "CMT-SR 3000" is equipped with a 4-point measuring head with sharp tips in order to penetrate layers on the metal layer like an anti-reflection and/or passivation layer. A current of 10 mA is applied to the 4 probes for 3 seconds. The measuring head, incorporating the 4 probes, is brought into contact with the non-metalized wafer material and the measuring of the voltage is started. The voltage is measured by a digital voltmeter (DVM) with a measuring range of 0 V to 2000 mV. After measuring 25 equally distributed spots on the wafer, the average sheet resistance p is calculated in Ω·cm.

The pin spacing of the four probes was 0.635 mm ∼ 1.27 mm, wherein:
- Pin Load: 10 gram/pin ∼ 250 gram/pin, preferably about 20 gram/pin.
- Pin radius: 12.5 µm ∼ 500 µm (polished 2 µm diamond), preferably 100 µm
- Tolerance: ± 0.01 mm
- Pin Needles: Solid Tungsten Carbide ϕ0.40 mm

The measuring time was 3 ± 1 sec/point.

### Determination of the layer thickness after heat treatment

A Mahr Perthometer (Mahr, Germany) with a Mahr Serial Device at a speed of 0.5 mm/s was used to detect the film thickness after a portion of the film has been removed from the substrate by means of scratching (without destruction of the substrate). The measurement takes place at the scratch and is repeated 5 times and averaged.

### Adhesion test

For the conductive silver layers that have been applied onto the PET-substrate the adhesion was determined in a *"cross cut adhesion test".* This adhesion test was performed with a Byk Gardner Cross-Cut-Tester (1 mm, DIN/ISO with 6 blades) and tape 3M #810. A sintered layer is cut two times in a 90° angle. Scotch tape #810 is pressed with a finger nail on the cut area and is torn away in a 90° angle to substrate. The test is "*passed*", if no removal of the sintered layer is observed, whereas the test is *"failed"* if there is a removal of at least a part of the sintered layer.

### EXAMPLES

In the following Examples 1 to 6 different precursor compositions are prepared. These precursor composition were applied on a PET-foil and on glass by means of screen printing (400 mesh steel with 10 µm emulsion) and dried under the conditions mentioned below. From the resulting layered bodies the resistivity and the thickness of the layered bodies (FTT = film thickness after heat treatment) were determined. Furthermore, from the conductive silver layers that have been applied onto the PET-substrate the adhesion was determined in a "*cross cut adhesion test"* (see the results in table 1).

### Example 1 (according to the present invention)

In sum 60.60 g of silver neodecanoate were dissolved at 60 °C in small portions in a mixture of 23.73 g terpineol and 4.43 g neodecanoic acid by stirring. To this solution 11.22 g of cyclohexanonoxime were added and stirred at 60 °C for further 2 hours. The mixture is passed over a dribble roll mill after cooling down to room temperature. A light yellow, viscous material is received.

| | |
|---|---|
| Silver neodecanoate | 60.60 % |
| Neodecanic acid | 4.43 % |
| Terpineol | 23.73 % |
| Cyclohexanonoxime | 11.22 % |
| | |
| Metal content: | 22.75 % |
| Viscosity: | 12750 mPas |
| | (Physica MCR 301, CP = 25-1 T = 20°C, D = 100 sec⁻¹) |

a) Specific resistance: 1.84 × 10⁻⁵ Ω·cm sintered at 150 °C, 60 minute peak on PET Specific surface resistance: 131.72 mΩ/sq FFT: 1.4 µm
b) Specific resistance: 8.94 × 10⁻⁷ Ω·cm sintered at 280 °C, 30 minute peak on glass Specific surface resistance: 17.88 mΩ/sq FFT: 0.5 µm

### Example 2 (according to the present invention)

In sum 54.29 g of silver neodecanoate were dissolved at 60 °C in small portions in a mixture of 29.37 g terpineol and 3.94 g neodecanoic acid by stirring. To this solution 9.97 g of cyclohexanonoxime are added and mixture is stirred at 60 °C for further 2 hours. Then 5.31 g of 2,5-dimethyl-2,5-hexandiol and 1.33 g of di-(trimethylol)propane are added and stirred at 60 °C for further 2 to 3 hours. After cooling to room temperature resulting material is passed three times over a dribble roll mill.

| | |
|---|---|
| Silver neodecanoate | 54.29 % |
| Neodecanic acid | 3.94 % |
| Terpineol | 25.16% |
| Cyclohexanonoxime | 9.97 % |
| 2,5-dimethyl-2,5-hexandiol | 5.31 % |
| Di-(trimethylol)propane | 1.33 % |
| | |
| Metal content: | 20.36 % |
| Viscosity: | 8610 mPas |
| | (Physica MCR 301, CP = 25-1 T = 20°C, D = 100 sec⁻¹) |

a) Specific resistance: 1.06 × 10⁻⁵ Ω·cm sintered at 150 °C, 60 minute peak on PET Specific surface resistance: 132 mΩ/sq FFT: 0.8 µm
b) Specific resistance: 2.6 × 10⁻⁶ Ω·cm sintered at 280 °C, 30 minute peak on glass Specific surface resistance: 37.16 mΩ/sq
   FFT: 0.7 µm

### Example 3 (according to the present invention)

In sum 63.07 g of silver neodecanoate were dissolved at 60 °C in small portions in a mixture of 23.38 g terpineol and 4.55 g neodecanoic acid by stirring. To this solution 9.00 g of 2-butanoneoxime were added and stirred at 60 °C for further 2 hours. After cooling down to room temperature the mixture is passed over a dribble roll mill. A light yellow, viscous material is received.

| | |
|---|---|
| Silver neodecanoate | 63.07 % |
| Neodecanic acid | 4.55 % |
| Terpineol | 23.38 % |
| 2-Butanoneoxime | 9.00 % |
| | |
| Metal content: | 23.60 % |
| Viscosity: | 4790 mPas |
| | (Physica MCR 301, CP = 25-1 T = 20°C, D = 100 sec⁻¹) |

a) Specific resistance: 1.11 × 10⁻⁵ Ω·cm sintered at 150 °C, 60 minute peak on PET Specific surface resistance: 170.44 mΩ/sq
   FFT:0.65 µm
b) Specific resistance: 2.63 × 10⁻⁶ Ω·cm sintered at 280 °C, 30 minute peak on glass Specific surface resistance: 26.34 mΩ/sq
   FFT: 1.0 µm

### Example 4 (not according to the present invention)

In sum 66.67 g of silver neodecanoate are dissolved in small portions in 33.33 g of 60 °C warm terpineol by stirring. After cooling material is passed over a dribble roll mill.

| | |
|---|---|
| Metal content: | 25.5 % |
| Viscosity: | 347000 mPas |
| | (Physica MCR 301, CP = 25-1 T = 20°C, D = 100 sec⁻¹) |

a) Specific resistance: 3.45 × 10⁻⁴ Ω·cm sintered at 150 °C, 60 minute peak on PET Specific surface resistance: 3830 mΩ/sq
   FFT: 0.9 µm
b) Specific resistance: 6.01 × 10⁻⁷ Ω·cm sintered at 280 °C, 30 minute peak on glass Specific surface resistance: 10.16 mΩ/sq
   FFT: 0.6 µm

### Example 5 (not according to the present invention)

18.8 g from Example 1 are mixed with a solution of 0.8 g ketone resin in 0.4 g terpineol.

| | |
|---|---|
| Example 1: | 94.0 % |
| Laropal A81 (ketone resin): | 4.0 % |
| Terpineol: | 2.0 % |
| | |
| Metal content: | approx. 24.4 % |

a) Specific resistance - not measurable sintered at 150 °C, 60 minute peak on PET Specific surface resistivity - no conductivity
   FFT: 1.4 µm
b) Specific resistance: 8.94 × 10⁻⁷ Ω·cm sintered at 280 °C, 30 minute peak on glass Specific surface resistance: 17.88 mΩ/sq
   FFT: 0.5 µm

### Example 6 (not according to the present invention)

19.4 g from Example 1 are mixed with a solution of 0.4 g Ketone resin in 0.2 g terpineol.

| | |
|---|---|
| Example 1: | 97.0 % |
| Laropal A81 (ketone resin): | 2.0 % |
| Terpineol: | 1.0 % |
| | |
| Metal content: | approx. 22.2 % |

a) Specific resistance: 5.38 × 10⁻⁵ Ω·cm sintered at 150 °C, 60 minutes peak on PET Specific surface resistance: 598.6 mΩ/sq.
   FFT: 0.9 µm

**Table 1**

| Example | specific resistivity [Ohm/cm] | specific surface resistance [mΩ/sq] | film thickness [µm] | adhesion |
|---|---|---|---|---|
| 1 | 1.84 × 10⁻⁵ | 131.72 | 1.4 | passed |
| 2 | 1.06 × 10⁻⁵ | 132 | 0.8 | passed |
| 3 | 1.11 × 10⁻⁵ | 170.44 | 0.65 | passed |
| 4 | 3.45 × 10⁻⁴ | 3830 | 0.9 | failed |
| 5 | not measurable | no conductivity | 1.4 | passed |
| 6 | 5.38 × 10⁻⁵ | 598.6 | 0.9 | passed |

## Claims

1. A precursor composition comprising
i) at least one silver precursor compound;
ii) at least one reducing agent;
iii) at least one solvent being different from components i) and ii);
iv) optionally at least one additive being different from components i), ii) and iii); wherein the precursor composition comprises less than 0.1 wt.-%, based on the total weight of the precursor composition, of a binder.

2. The precursor composition according to claim 1, wherein the at least one reducing agent ii) is an oxime.

3. The precursor composition according to claim 2, wherein the at least one oxime ii) is selected from the group consisting of acetone oxime, acetaldoxime, methyl ethyl ketone oxime, 2-butanonoxime, methyl isobutyl ketone oxime, cyclohexanone oxime, acetophenone oxime, benzophenone oxime, methylglyoxal oxime, ethylglyoxal oxime, methylaldoxime or a mixture of at least two thereof.

4. The precursor composition according to anyone of the preceding claims, wherein the at least one additive iv) is selected from the group consisting of a stabilizer, a defoamer, a viscosity adjusting agent and an adhesion agent.

5. The precursor composition according to anyone of the preceding claims, wherein the at least one silver precursor compound i) is a metal-organic silver compound.

6. The precursor composition according to anyone of the preceding claims, wherein the metal-organic silver compound i) is silver neodecanoate.

7. The precursor composition according to anyone of the preceding claims, wherein the at least one solvent iii) has a boiling point determined at 1013 mbar of at least 60°C.

8. The precursor composition according to claim 7, wherein the at least one solvent iii) is terpineol.

9. The precursor composition according to anyone of the preceding claims, wherein the precursor composition comprises less than 0.1 wt.-%, based on the total weight of the precursor composition, of a binder selected from the group consisting of polypyrrolidone, epoxies, phenolic resins, acrylics, urethanes, silicones, styrene allyl alcohols, polyalkylene carbonates, polyesters and polyvinyl acetals and combinations thereof.

10. The precursor composition according to anyone of the preceding claims, wherein the precursor composition comprises
- 5 to 80 wt.-% of the at least one silver precursor compound i);
- 1 to 20 wt.-% of the at least one reducing agent ii);
- 10 to 90 wt.-% of the at least one solvent iii);
- 0.05 to 10 of at least one additive iv);
wherein total amount of components i) to iv) is 100 wt.-%.

11. A process for preparing a layered body comprising a substrate and a metal layer superimposed onto at last a part of at least one surface of the substrate, comprising the process steps:
I) providing a substrate;
II) superimposing at least a part of at least one surface of the substrate with the precursor composition according to anyone of the preceding claims;
III) applying an external energy source to convert the precursor composition into a metal layer comprising silver.

12. The process according to claim 11, wherein the substrate is selected from the group consisting of a polymer, a metal, a paper, a ceramic, a glass or a combination of at least two thereof.

13. A layered body obtainable by the process according to claim 11 or 12.

14. The layered body according to claim 13, wherein the metal layer is **characterized by** at least one of the following properties:
P1) a resistivity less than 1 × 10⁻⁴ Ω·cm;
P2) a thickness of less than 2 µm.

15. An electronic component comprising a layered body according to claims 13 or 14.

16. The electronic component of claim 15, wherein the electronic component is selected from the group consisting of an Organic Light Emitting Diode (OLED), a Light Emitting Diode (LED), a display, a transistor, a capacitor, a smart tag, a smart label, a radio frequency identification (RFID) tag, a sensor, a circuit, a touch screen, a light emitting electrochemical cell, an antistatic coating, an ESD shielding layer and a solar cell.
